# EUROPEAN PATENT APPLICATION

(11) **EP 0 579 010 A1**
(43) Date of publication of application: **19.01.1994**
(21) Application number: 93110085.3
(22) Date of filing: 24.06.1993
(51) Int. Cl.: H05K 5/00, H01L 23/14, H01B 5/00

(54) **Lightweight packaging**

(30) Priority: 07.07.1992 US 909925
(71) Applicant: International Business Machines Corporation, Armonk, N.Y. 10504 (US)
(72) Inventor: Horton, Raymond Robert, Dover Plains, New York 12522 (US); Noyan, Ismail Cevdet, Yorktown Heights, New York 10598 (US); Palmer, Michael Jon, Walden, New York 12586 (US); Pence, William Edward IV, Tarrytown, New York 10591 (US)
(74) Representative: Rach, Werner, Dr.

(57) **Abstract**

Electronic packaging using a composite material having the combined properties of permeability, selectable density and electrical conductivity provide improved shock resistance, electrical shielding, convection cooling, heat transfer and weight reduction. Particularly adaptable for portable electronic apparatus.

## Description

The invention relates to the packaging of somewhat fragile equipment, such as electronic apparatus, and in particular to high density, lightweight, electronic packaging with convection cooling.

The technology of arranging and supporting electronic components for use as a functional apparatus has come to be referred to in the art as packaging. Fragile equipment and electronic apparatus packaging generally provides a housing for the signal processing elements or devices that permits them to operate in the designed manner while still protecting them from potentially detrimental hazards encountered in conditions of use. As the equipment and the electronic apparatus becomes smaller and more portable, the density and sensitivity of the devices require greater cooling ability and physical protection while the applications in which use will take place, such a cellular phones and laptop computers require ever diminishing weight and physical volume together with increased hazard protection. Portable devices are more difficult to cool, more complex to wire; they can be placed near radiating equipment and they are subject to being dropped. In packaging design, it is becoming very difficult to meet all the conflicting criteria with the conventional properties of materials.

The cooling aspect of the packaging art is illustrative of the structure involved and the progress being made.

In cooling, heat that is locally generated at a signal processing device must be transferred to the ambient outside the structure. As device density and performance go up, the heat transfer criteria becomes more difficult to achieve without the transfer from one device affecting another. In U.S. Patents 4,783,721 4,879,632 and 4,920,574 a metal bellows structure accommodates expansion differences between heat generating semiconductor chip devices and a common heat transfer fluid conduit.

In U.S. Patent 5,029,638 the increased area property of permeable material is employed in fins in a heat exchanger that improves conduction of the heat from the chip to the heat transfer fluid thereby reducing need to accommodate as much expansion. The progress of U.S. Patent 5,029,638, on cooling alone, involves significant additional structure which may not be tolerable if there are other and conflicting requirements in the direction compactness and weight. Current efforts in portable electronic apparatus are directed to confining total weight including the case to less than 4 lbs. To achieve such low weight, new materials will be needed.

The invention uses the properties acquired through permeability in packaging. The invention includes, as an electronic packaging component, a material having the combined physical properties of a permeable solid structure, selectable density and electrical conductivity. The material may have some properties that are inherent and others that are imparted. The component is employed, together with device supporting and external wear protecting members, as an electrical shielding, convective cooling, shock absorbing, apparatus case. The component is also employed as, a convective cooling enhancing, wiring conductor. An apparatus or workpiece is described with a metal foam between a device supporting laminate and an external wear protection laminate with metal foam tape internal conductors.

FIG. 1 is a schematic side view of the packaging component of the invention.

FIG. 2 is a microscopic view of the preferred embodiment, metal foam.

FIG. 3 is a schematic side view of the conductive, permeable, selectable density component with a device supporting member on one surface.

FIG. 4 is a schematic side view of the conductive permeable, selectable density component with a device supporting member on one surface and a wear protection member on the other surface.

FIG. 5 is a schematic side view of a wiring cable of a conductive permeable material.

FIG. 6 is a schematic view of a permeable material, the solid structure of which is an arrangement of filamentary members.

FIG. 7 is a perspective view of a two conductor wiring cable with a conductive permeable material backing and insulated conductors.

FIG. 8 is a perspective side view of a somewhat fragile workpiece or electronic apparatus case employing the invention.

FIG. 9 is a top view of a schematic showing multiple panels of the component of the invention with channels between them on a housing.

In the packaging of somewhat fragile workpieces, sensitive equipment or electronic apparatus, as down-sizing and expansion of sues occurs, a number of interdependent items take on increasing importance.

In accordance with the invention, a packaging component is provided that employs the properties of permeability. A composite material is employed that has the physical properties of a permeable solid structure, a selectable density and electrical conductivity. The physical properties permit design flexibility heretofore unavailable in the art in heat transfer, structural support, shock resistance all achieved with less weight.

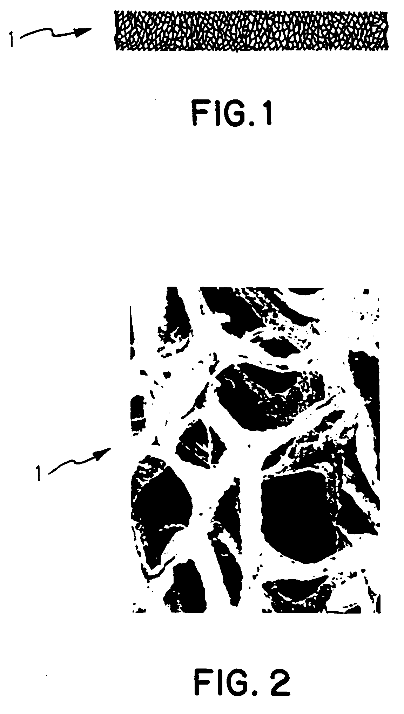

Referring to FIG. 1, a schematic side view of the component of the invention is shown. The component 1 is an appropriately dimensioned quantity of a permeable material, that is, having the combined physical properties of: a permeable solid structure and electrical conductivity. Under some applications, the additional physical property of selectable density of the permeable solid structure is employed. The combined physical properties provide a packaging component that can permit air to pass through it in all directions, can be provided with a wide range of heat transfer and structural support properties, can conduct electricity and can serve as an electrical shield. The physical property of a permeable solid structure that is a solid structure with interstices in which another material can pass and which is compressible, can be provided by randomly arranged filamentary members such as the metal foam material in the art.

The physical property of a selectable density can be provided by the number of solid members that are present in a unit space. Where the material is a metal, the required physical property of electrical conductivity is a property of the metal whereas, if for example the filamentary members were other than metal, the physical property could be imparted through vacuum metallization of the solid members.

Referring next to FIG. 2, there is provided a microscopic view of the preferred embodiment, metal foam, in a dimensioned quantity to serve as a packaging component, mounted on a lamination not visible in the picture. The metal foam material is also known in the art as "FOAMETAL". It is a web structure of fused metal filaments in a three dimensional skeletal arrangement. One manufacturer is Hogen Industries Inc., Mentor, Ohio, USA. The filamentary members can be specified in the art in a wide range of densities which in turn permits the permeability of the material to be specified. The greater the permeability and the less dense the material is, the more it will deform under stress and the more cooling air can pass through, transferring more heat out of it. The less permeable and more dense the material is, the stronger and more protective under stress it will be and the better it will conduct heat.

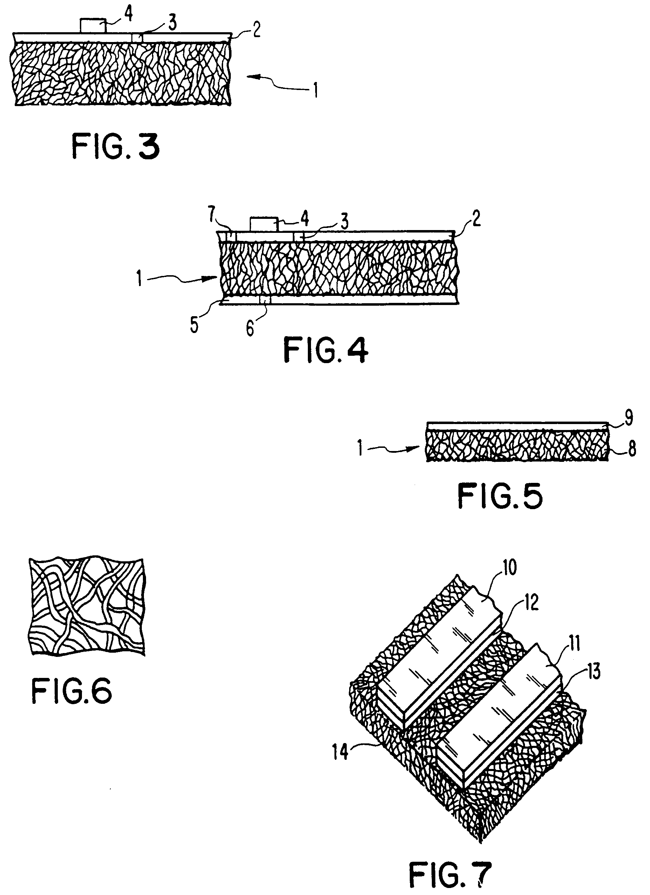

In FIGS. 3, 4 and 5 there is shown different electronic packaging members employing the component material, in accordance with the invention.

Referring to FIG. 3, a schematic side view is provided of the component material 1 with a device supporting member 2 on one surface. On the device supporting member 2, the signal processing members of the electronic apparatus being packaged are placed. The member 2 can be an insulating laminate or series of laminates that support signal processing members, such as chips, and can accommodate associated interconnections, such as by printed wiring techniques on a lamination. Openings, shown as member 3, may be placed in the member 2 to permit air in the material 1 to flow in an overall cooling pattern that may involve either or both forced and convection in the apparatus being packaged. A signal processing member 4 positioned and interconnected through the structural members of the material 1 and transferred to the air in the material 1 and out the opening 3.

Referring to FIG. 4, a schematic side view is provided of the component material 1 with a device supporting member 2 on one surface and a wear protection member 5 on the other surface. The wear protection member 5 may be an insulating or metal lamination. The members 2 and 5 may be attached to the material 1 using adhesive techniques or where metals are involved solder may be used. Openings, such as hole 6, may be selectively placed on the member 5 to let ambient air into or out of the material 1. In FIG. 4, the hole 6 is positioned to cause air to flow both toward the signal processing member 4 which is radiating heat into the material 1 and parallel with the members 2 and 5 so as to come out both holes 3 and 7 on each side of the localized heat source 4.

Referring next to FIG. 5, a schematic side view of an appropriately dimensioned member 8 of the material 1 supporting an insulated conductor 9 for use as a wiring cable. As electronic apparatus is downsized, it becomes necessary to mount signal processing elements on the side and cover of the overall housing. Under such conditions, planar wiring is not always feasible and unsupported cabling is useful. Such cabling, however, produces cooling problems in that there are shadow areas where the air flow is affected by the presence of the cables. In the cable of FIG. 5, the air can flow through the material 8, cooling any resistance produced heat or IR drop in the cable itself and reducing air flow disruption problems. Where the electrical criteria will permit, the conductor 9 may not be needed and greater air flow through the material 1 will occur. The thickness dimension of the material 1 in FIG. 5 need only be sufficient for support and the thinner it is the more flexible it will be.

In FIG. 6, a schematic view if provided of a type of material having the combined permeable solid structure and selectable density physical property requirements of the invention.

Referring to FIG. 6, in the material there are many solid filaments in a random or amorphous arrangement. The density of the filaments can be varied over a wide range. A preferred material of this type is known in the art as metal foam. Sintered and honeycomb structural materials are also usable. It can be specified as to density and particular metal. The permeability and density control the amount of cooling air that will pass through the material. The particular metal controls the electrical conductivity. In somewhat fragile workpiece type housing and portable apparatus packaging, the ability to handle shock is of high importance. It is possible to protect a workpiece or apparatus with a solid enclosure but if the enclosure is dropped, the shock is transmitted undiminished to the workpiece or apparatus. The selectable density permeability of the material permits specifying an acceptable deformation for a given magnitude of shock.

In FIG. 7 a schematic illustration is provided showing a two conductor tape cable where the conductors 10 and 11 are each insulated by elements 12 and 13, respectively, from a tape 14 of the permeable, electrically conductive component of the invention. The cable structure permits of electrical characteristic impedance control by relative positioning of the conductors 10 and 11 with respect to each other and strip line impedance control of each conductor relative to the element 14 serving as a ground plane. The material of the invention as employed as element 14 permits cooling air flow through the element between and on all sides of the conductors 10 and 11. It will be apparent that one skilled in the art in the light of the principle set forth could employ the component of the invention as an air permeable substrate for the mounting of a chip or chips.

A particularly useful application of the invention is achieved in providing a Faraday cage or shielded case and wiring in portable housing of a somewhat fragile workpiece and electronic apparatus.

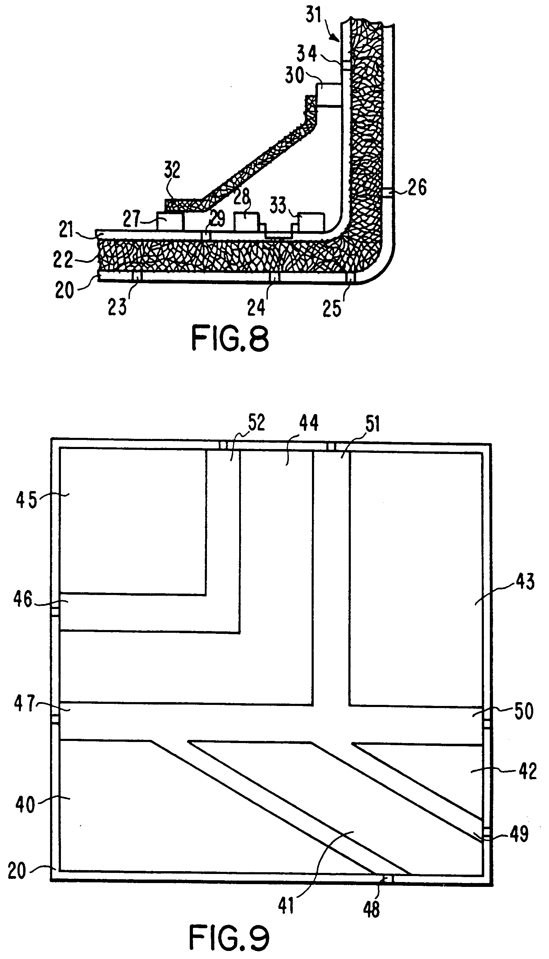

Referring to FIG. 8, a perspective side view of a portion of the case and exemplary wiring is shown. The case is made up of an outside or wear resistant laminate 20 of, for example, a formic aldehyde resin and an inside or device supporting member 21 of a standard printed circuit board material with the region between of the permeable selectable density conductive material 22 of the invention. The portion of the case shown in FIG. 8 involves two sides meeting at a corner. Holes 23-26 are shown in the outside laminate 20 for the ingress and egress of a cooling fluid, air in this application. The air holes 23-26 are positioned to be part of an overall convective air flow pattern for the apparatus being packaged. Even though in critical weight workpiece housing and apparatus it is mostly desirable to rely on convective air flow in instances where forced air flow is needed, improved operation is achieved where the forced flow is superimposed on an optimized convective pattern. In the example pattern of FIG. 8, holes 23 and 24 are positioned for air flow that is horizontal under devices 27 and 28, whereby heat, radiated into, and conducted into, the material 22 by the filaments of the material 22 is transferred to the cooling air flowing from the holes 23 and 24 to hole 29. Device 30 is positioned on the side portion 31 of the case and is electrically served by unsupported cable 32 connecting devices 27 and 30, with the convection cooling pattern being such that air from hole 29 passes through the cable 32. Devices 28 and 33 are electrically interconnected by wiring in the laminate 21. Heat radiated and conducted into the material 22 from devices 28 and 33 is transferred by the cooling air from hole 24 being drawn into the air flow in side 31 through holes 25 and 26 with regress being at least at hole 34. In general, the convection pattern provides air flow from ingress, along a path parallel to the device supporting laminate under each device or local heat source , to egress, and where the egress air can pass through any cabling in the path.

The structure of elements 21, 22 and 23 provides, when the structure is fully closed, a shock resistant, electrically shielded case for the packaged apparatus. The deformability of the material 22 in all directions provides shock resistance for any housed workpiece, the devices and the wiring. The ability to select density permits localized reinforcement where desired. A 13 inch by 10 inch by 1 inch case of the inventive packaging would weigh 350 grams, which is 280 grams less than a solid case.

The capability of tailoring the density of the component material together with the ability to provide discrete sections meeting different criteria is useful in weight reduction, localized special heat dissipation and localized reinforcement. The packaging component of the invention can be made in area quantities to specific criteria which can then be cut apart and different criteria quantities used in different locations with low drag coefficient channels between. A schematic illustration is provided in FIG. 9 which is a top view of the bottom of a case similar to that, a section of which is shown in FIG. 8 at the level below the device supporting laminate 21. In FIG. 9 sections 40-45 are shaped portions of the component material 22. Illustratively, sections 40-42 are tailored for high air flow in cooling and thus have lower density whereas sections 43-45 are tailored for higher shock resistance and thus have higher density. Between sections, channels 46-52 with holes to the outside are provided. The channels operate to enhance air flow and reduce weight.

What has been described is a packaging principle wherein a component of a composite material having properties that enhance such factors as shock resistance, electrical shielding, convection cooling, heat transfer and weight reduction is selectively employed in the overall package structure.

## Claims

1. In a structure for packaging apparatus including at least one of a workpiece and circuitry, the improvement comprising:
surrounding said apparatus with a housing including a permeable material.

2. The improvement of claim 1 further including surrounding said apparatus with a material having an electrical conductive property.

3. The improvement of claim 1 wherein said permeable material is conductive.

4. A structure for packaging apparatus including at least one of a workpiece and circuitry comprising:
an enclosure having an inner and an outer wall,
a permeable foam between said inner and out wall,
electrical circuitry at said inner wall for interaction with a workpiece and at least one aperture in said outer wall.

5. In an electronic apparatus, a packaging member having the combined physical properties of permeability, selectable density and electrical conductivity.

6. The packaging member of claim 5 wherein said member is of metal foam.

7. The packaging member of claim 1 including an electronic device supporting insulating laminate member on a first surface thereof.

8. The packaging member of claim 7 including a wear resistant laminate member on a second surface thereof.

9. An electronic tape type conductor comprising a flexible tape body of a material having the combined properties of permeability, selectable density and electrical conductivity.

10. The tape conductor of claim 9 including an insulated conductor on one surface of said tape body.

11. The tape conductor of claim 9 including at least two electrical characteristic impedance controlled conductors.

12. A structure for housing electronic apparatus comprising:
an enclosure having an inner wall and an outer wall,
a material having the combined properties of permeability, selectable density and electrical conductivity between said inner wall and said outer wall,
electronic circuitry at said inner wall, and
at least one aperture in said outer wall.

13. The structure of claim 12 wherein said material with combined properties is metal foam.

14. In the packaging of electronic apparatus, the improvement comprising the surrounding of said electronic apparatus with a case including a material having the combined properties of permeability, selectable density and electrical conductivity.
